# FASCICULE DE BREVET EUROPEEN

(11) **EP 2 609 638 B1**
(45) Date de publication et mention de la délivrance du brevet: **03.12.2014**
(21) Numéro de dépôt: 11746628.4
(22) Date de dépôt: 15.07.2011
(51) Int. Cl.: H01L 43/10, H01L 43/12, H01L 21/20

(54) **METHODE DE PREPARATION D'UN SUBSTRAT DE GaAs POUR SEMI-CONDUCTEUR FERROMAGNETIQUE, PROCEDE DE FABRICATION D'UN TEL SEMI-CONDUCTEUR, SUBSTRAT ET SEMI-CONDUCTEUR OBTENUS ET UTILISATIONS DE CE DERNIER**
VERFAHREN ZUR HERSTELLUNG EINES GaAs-SUBSTRATS FÜR EINEN FERROMAGNETISCHEN HALBLEITER, VERFAHREN ZUR HERSTELLUNG EINES DERARTIGEN HALBLEITERS, RESULTIERENDES SUBSTRAT UND HALBLEITER SOWIE VERWENDUNG DIESES HALBLEITERS
METHOD FOR PREPARING A GaAs SUBSTRATE FOR A FERROMAGNETIC SEMICONDUCTOR, METHOD FOR MANUFACTURING ONE SUCH SEMICONDUCTOR, RESULTING SUBSTRATE AND SEMICONDUCTOR, AND USES OF SAID SEMICONDUCTOR

(30) Priorité: 24.08.2010 FR 1003426
(43) Date de publication de la demande: 03.07.2013
(73) Titulaire: Commissariat à l'Énergie Atomique et aux Énergies Alternatives, 75015 Paris (FR)
(72) Inventeur: BARSKI, André, F-38430 Moirans (FR); JAMET, Matthieu, F-38500 Voiron (FR)
(74) Mandataire: Bolinches, Michel Jean-Marie
(86) Numéro de dépôt international: PCT/IB2011/053170
(87) Numéro de publication internationale: WO 2012/025841

(56) Documents cités:
- EP-A1- 1 705 665
- WO-A1-2007/090946
- WO-A1-2010/010250
- HIRO AKINAGA ET AL: "Semiconductor Spintronics", IEEE TRANSACTIONS ON NANOTECHNOLOGY, IEEE SERVICE CENTER, PISCATAWAY, NJ, US, vol. 1, no. 1, 1 mars 2002 (2002-03-01), XP011077057, ISSN: 1536-125X

## Description

La présente invention concerne une méthode de préparation d'une surface d'un substrat à base de GaAs (001) pour la rendre apte à recevoir un semi-conducteur ferromagnétique déposé par épitaxie, un substrat ainsi préparé, un procédé de fabrication d'un tel semi-conducteur déposé sur ce substrat, ce semi-conducteur ainsi obtenu et ses utilisations. L'invention s'applique à des semi-conducteurs des groupes III-V, IV-IV ou II-VI de la classification périodique des éléments et en particulier à des semi-conducteurs du groupe IV à base de germanium.

L'injection dans un semi-conducteur d'un courant de porteurs polarisé en spin, qui se caractérise par un excès de l'une des deux populations de porteurs présentes (par exemple celle de spin parallèle ou « spin up »), a fait l'objet de plusieurs publications. On peut par exemple citer, à titre exemplatif, les composants électroniques décrits dans l'article Datta et Das, Applied Physics Letters, 56, 665, 1990.

La mise en oeuvre de cette injection d'un courant polarisé en spin présente un grand intérêt en microélectronique, mais son développement se heurte au manque de matériaux appropriés pour constituer l'électrode d'injection du courant.

En effet, si les métaux ferromagnétiques usuels, tels que le fer et nombre de ses alliages, présentent une part des qualités requises comme une polarisation en spin élevée et un comportement ferromagnétique à température ambiante, leur résistance électrique est de plusieurs ordres de grandeur différente de celle des semi-conducteurs, ce qui génère de grandes difficultés de mise en oeuvre et impose d'effectuer l'injection de courant par effet tunnel. Cela a pour inconvénient de nécessiter la croissance d'une hétéro-structure hybride malaisée à réaliser, du type semi-conducteur/ barrière à effet tunnel/ métal ferromagnétique.

A l'opposé, il existe des semi-conducteurs dits magnétiques dilués (en abrégé « DMS » en anglais, pour « Diluted Magnetic Semiconductors ») qui ne présentent pas cet inconvénient de posséder une résistivité très différente de celle des semi-conducteucs ordinaires. Ces « DMS » sont typiquement constitués d'une matrice semi-conductrice des groupes III-V, IV ou II-VI dans laquelle sont diluées des impuretés magnétiques comme le manganèse, le fer, le chrome, le cobalt ou le nickel.

Le document de Brevet WO-A1-2007/090946 au nom de la Demanderesse a démontré qu'un dépôt par épitaxie par jets moléculaires (« EJM » en français ou « MBE » en anglais pour Molecular Beam Epitaxy ») à basse température, sur un substrat de germanium monocristallin, d'un semi-conducteur du groupe IV tel que le germanium comprenant en outre un élément magnétique tel que le manganèse, ce semi-conducteur étant déposé sous la forme d'une couche mince modulée latéralement par des nano-colonnes ferromagnétiques continues qui sont riches en manganèse et qui sont séparées entre elles par une matrice pauvre en manganèse, permet de conférer à ce semi-conducteur par exemple de type GeMn des propriétés ferromagnétiques exceptionnelles, caractérisées par une température de curie pouvant être supérieure à 350 K, voire à 400 K.

La demande internationale WO 2010/010250 divulgue un procédé de fabrication d'un semi-conducteur comprenant le dépôt d'un semi-conducteur ferromagnétique par épitaxie sur un substrat de GaAs. Avant le dépôt du semi-conducteur ferromagnétique, le substrat est soumis à une désoxydation pour obtenir une surface suffisamment propre par un nettoyage chimique ou un traitement de plasma et à un dépôt d'une couche tampon de germanium par épitaxie.

Or, si l'on souhaite étudier les propriétés de magnéto-transport dans un tel semi-conducteur, il est nécessaire que les porteurs de charges restent confinés dans la couche mince de GeMn déposée sur le substrat par application d'un courant électrique, et l'on sait qu'il n'existe pas de substrat en germanium semi-isolant de qualité suffisante pour réaliser l'épitaxie ultérieure de GeMn à la surface de ce substrat avec les propriétés ferromagnétiques recherchées pour ce semi-conducteur.

Bien qu'il existe des substrats isolants de GaAs d'excellente qualité cristallographique qui pourraient être théoriquement utilisés pour la croissance de GeMn, il s'avère en pratique que la préparation de la surface de ces substrats connus de GaAs ne rend pas cette surface adaptée pour le dépôt par épitaxie de GeMn notamment du fait que cette surface de GaAs est riche en arsenic à l'issue de sa préparation ce qui fait diffuser le fort dopant n qu'est l'arsenic dans la couche de GeMn en dopant ainsi ce dernier de manière indésirable et donc en altérant les propriétés magnétiques du semi-conducteur GeMn.

On peut citer les méthodes usuelles suivantes pour la préparation d'un substrat de GaAs, qui présentent cet inconvénient commun de conduire à un fort taux d'arsenic de la surface de GaAs.

Selon une première méthode par exemple utilisée en vue de l'homoépitaxie du GaAs, on chauffe sous vide le substrat de GaAs à une température de l'ordre de 600° C sous flux d'arsenic, ce qui permet de désoxyder la surface du substrat par la désorption de l'oxyde d'arsenic et de gallium et de garder la bonne planéité de cette surface. Par ce traitement thermique, on forme une surface de GaAs (001) reconstruite 2x4 et riche en arsenic (étant précisé que sans flux d'arsenic la surface du substrat s'appauvrirait en arsenic et par conséquent deviendrait rugueuse, ce qui nuirait à la qualité du dépôt ultérieur par épitaxie). Si l'on dépose par épitaxie sur cette surface riche en arsenic un film semi-conducteur non pas à base de GaAs mais de GeMn, il s'avère que ce film de GeMn ne possède pas les propriétés magnétiques recherchées. Or, dans un bâti d'épitaxie dédié à la croissance de semi-conducteurs du groupe IV et plus particulièrement de GeMn, on ne peut pas placer une source d'évaporation d'arsenic car celui-ci conduirait irrémédiablement à la forte pollution du semi-conducteur déposé du fait du dopage résiduel n trop important de l'arsenic et de la faible énergie d'activation correspondante (14 meV).

Selon une deuxième méthode, on peut utiliser des surfaces de GaAs (001) préparées par épitaxie par jets moléculaires sous flux d'arsenic et recouvertes par une fine couche d'arsenic amorphe, avec transfert à l'air de l'échantillon de GaAs ainsi préparé puis placement de cet échantillon dans un bâti d'épitaxie de GeMn. On y évapore alors la couche d'arsenic amorphe, ce qui conduit à l'obtention d'une surface de GaAs reconstruite 2x4, riche en arsenic et, comme précédemment, le dépôt de GeMn sur cette surface induit une forte diffusion de l'arsenic dans le film de GeMn qui devient de type « n » par ce dopage et ne possède donc plus les qualités structurales et magnétiques recherchées.

Pour contourner ce problème, on a cherché à transférer sous vide le substrat de GaAs préparé selon cette deuxième méthode d'un bâti d'épitaxie dédié à GaAs vers un autre bâti d'épitaxie dédié à GeMn mais sans parvenir à éviter cette pollution du GeMn puisqu'avec cette dernière méthode la surface de GaAs reconstruite 2x4 est toujours riche en arsenic et diffuse donc dans le film de GeMn. De plus, cette dernière méthode impose soit de coupler les deux bâtis par un raccordement sous ultravide, soit de disposer d'une chambre spéciale appelée « valise de transfert sous ultravide », ces solutions étant très coûteuses et difficiles à mettre en oeuvre.

Un but de la présente invention est de remédier à l'ensemble des inconvénients précités, et ce but est atteint en ce que la Demanderesse vient de découvrir d'une manière surprenante qu'une désoxydation sous vide de la surface d'un substrat à base de GaAs (001) sous un flux réduit à base de germanium, comprenant une désorption de l'oxyde d'arsenic et de gallium de cette surface, permet d'obtenir en fin de désorption une reconstruction 2x1 mono-domaine pour cette surface qui est en outre suffisamment plane et appauvrie en arsenic pour éviter toute diffusion d'arsenic de ce substrat ainsi préparé vers un semi-conducteur ferromagnétique ultérieurement déposé par épitaxie, lequel est choisi dans le groupe constitué par ceux des groupes III-V, IV et II-VI de la classification périodique à l'exception de GaAs et comprend en outre au moins un élément magnétique choisi dans le groupe constitué par le manganèse, le fer, le cobalt, le nickel et le chrome.

Par « substrat à base de GaAs (001) », on entend dans la présente description tout substrat d'arséniure de gallium dopé ou non qui présente spécifiquement une orientation 001 (i.e. de manière bien connue parallèle au plan xy et qui coupe l'axe z) contrairement à l'orientation (111) dite A ou B qui n'est pas concernée par la présente invention.

Par « reconstruction 2x1 mono-domaine », on entend de manière connue un arrangement des atomes sur la surface de GaAs qui forment des liaisons pour compenser la rupture de continuité du cristal, ce qui forme une surface mono-domaine c'est-à-dire de très bonne qualité. Cette reconstruction 2x1 mono-domaine qui apparaît à l'issue de la désoxydation du substrat a été précisément mise en évidence par la Demanderesse par la technique de diffraction d'électrons à haute énergie (« RHEED » en anglais pour « Reflection High-Energy Electron Diffraction »).

On notera que cette surface de GaAs (001) spécifiquement reconstruite 2x1 mono-domaine présente, outre un faible taux d'arsenic permettant d'éviter la pollution du film semi-conducteur ultérieurement déposé, contrairement à l'art antérieur précité, une excellente planéité en vue du dépôt ultérieur par épitaxie de ce semi-conducteur.

Selon une autre caractéristique de l'invention, cette méthode est mise en oeuvre dans un bâti d'épitaxie par jets moléculaires dédié au dépôt ultérieur dudit semi-conducteur ferromagnétique, par exemple dans un bâti dédié au dépôt d'un semi-conducteur de type GeMn.

Selon une autre caractéristique de l'invention, cette méthode de préparation de surface comprend en outre les étapes suivantes, mises en oeuvre dans ledit bâti d'épitaxie antérieurement à ladite désoxydation et de préférence à une température comprise entre 200 et 300° C :
a) un chauffage sous vide du substrat en particulier pour désorber l'eau et les molécules de CO et de CO₂ de la surface, puis
b) un dépôt sur la surface ainsi traitée d'une fine couche de germanium.

On notera que cette méthode de préparation de surface selon l'invention est ainsi bien adaptée à l'épitaxie du semi-conducteur sur cette surface de substrat et ne requiert pas des moyens additionnels complexes ni par conséquent coûteux.

Avantageusement, ledit flux de germanium au niveau du substrat lors de la désoxydation peut être compris entre 0,9 x 10⁻⁸ Torr et 1,3 x 10⁻⁸ Torr (1 Torr = 133,3 Pa), et ce flux correspond à une vitesse de croissance du germanium pouvant être comprise entre 0,10 nm/min. et 0,20 nm/min.

De préférence, la température du substrat lors de la désoxydation est comprise entre 500 et 600° C et, à titre encore plus préférentiel, sensiblement égale à 550° C.

Selon une autre caractéristique préférentielle de l'invention, dès l'apparition de ladite reconstruction 2x1 mono-domaine pour la surface, on supprime ledit flux de germanium et l'on abaisse la température du substrat à une valeur qui est proche de celle utilisée pour le dépôt ultérieur du semi-conducteur ferromagnétique et qui est de préférence comprise entre 80 et 200° C et par exemple entre 90 et 100° C dans le cas où ce semi-conducteur est à base de GeMn.

De préférence, on soumet le substrat audit flux de germanium lors de la désoxydation pendant une durée comprise entre 5 min. et 6 min., pour l'obtention finale sur la surface du substrat d'une fine couche de Ge d'épaisseur inférieure à 1 nm.

Ainsi, un substrat à base de GaAs (001) selon l'invention a sa surface qui est apte à recevoir un semi-conducteur ferromagnétique déposé par épitaxie qui est choisi dans le groupe constitué par les semi-conducteurs des groupes III-V, IV et II-VI de la classification périodique à l'exception de GaAs et qui comprend en outre au moins un élément magnétique choisi dans le groupe constitué par le manganèse, le fer, le cobalt, le nickel et le chrome, et cette surface présente une reconstruction 2x1 mono-domaine et est suffisamment pauvre en arsenic pour éviter toute diffusion d'arsenic de ladite surface vers ce semi-conducteur ferromagnétique.

Selon une autre caractéristique de l'invention, ce substrat est tel que sa surface est recouverte d'une fine couche de germanium d'épaisseur de préférence inférieure à 1 nm.

Un procédé de fabrication selon l'invention d'un semi-conducteur ferromagnétique qui est choisi dans le groupe constitué par ceux des groupes III-V, IV et II-VI de la classification périodique à l'exception du GaAs (étant de préférence à base de germanium) et qui comprend au moins un élément magnétique tel que le manganèse, le fer, le cobalt, le nickel et le chrome, comprend un dépôt par épitaxie par jets moléculaires (EJM) de ce semi-conducteur sur un substrat tel que défini et préparé comme indiqué ci-dessus dont la température pendant la croissance des cristaux est comprise entre 80 et 200° C et de préférence entre 90 et 100° C dans le cas où ce semi-conducteur est à base de GeMn.

Avantageusement, ce dépôt par épitaxie peut être réalisé sous ultravide par évaporation du germanium et dudit au moins un élément magnétique à partir de sources solides sur le substrat, le semi-conducteur ainsi déposé comprenant des nano-colonnes ferromagnétiques riches en cet élément qui sont perpendiculaires à ladite surface (i.e. parallèles à la direction de croissance des cristaux) et qui sont séparées entre elles par une matrice pauvre en cet élément, comme indiqué dans le document précité WO-A1-2007/090946 et avec obtention des températures de Curie très élevées mentionnées dans ce document.

On notera que l'utilisation d'une surface de GaAs (001) à la fois pauvre en arsenic et d'une bonne planéité est nécessaire pour réussir le dépôt de couches d'un tel semi-conducteur ferromagnétique. En particulier, si cette surface de GaAs était quelque peu rugueuse, alors les nano-colonnes déposées ne seraient plus parallèles à la direction de croissance des cristaux et la ou les couches épitaxiées ne posséderaient plus les propriétés ferromagnétiques recherchées.

On notera également que la température du substrat précitée pendant le dépôt du semi-conducteur, qui est faible en comparaison des températures de croissance de cristaux communément utilisées (notamment pour l'épitaxie d'un semi-conducteur du groupe IV qui est d'ordinaire réalisée à une température comprise entre 450 et 650° C), permet de stabiliser les phases métastables semi-conductrices ou nano-colonnes précitées riches en élément magnétique (e.g. Mn).

Un semi-conducteur ferromagnétique selon l'invention est choisi dans le groupe constitué par ceux des groupes III-V, IV et II-VI de la classification périodique à l'exception du GaAs, et il comprend au moins un élément magnétique choisi dans le groupe constitué par le manganèse, le fer, le cobalt, le nickel et le chrome, ce semi-conducteur étant de préférence à base de germanium et, à titre encore plus préférentiel, à base de GeMn.

Selon l'invention, ce semi-conducteur est déposé par épitaxie par jets moléculaires sur la surface d'un substrat tel que défini ci-dessus et il comprend des nano-colonnes riches en cet élément qui sont sensiblement perpendiculaires à ladite surface et qui sont séparées entre elles par une matrice pauvre en cet élément.

Une utilisation selon l'invention d'un tel semi-conducteur ferromagnétique peut avantageusement consister à injecter des spins dans le substrat ainsi préparé à base de GaAs (001), par exemple afin que ce substrat émette de la lumière sous forme de diodes électroluminescentes en combinant l'émission de la lumière avec une injection sélective polarisée en spin. En effet, le matériau GaAs, qui est à gap direct, présente l'avantage d'être un excellent émetteur de lumière.

Une autre utilisation selon l'invention d'un tel semi-conducteur ferromagnétique peut avantageusement consister à réaliser des transistors travaillant en courant polarisé en spin, ce courant circulant dans le semi-conducteur déposé sur ce substrat à base de GaAs (001).

Ces utilisations ne sont données qu'à titre d'exemples, étant entendu que d'autres utilisations de ce semi-conducteur ferromagnétique déposé sur un substrat GaAs (001) sont envisageables.

Les caractéristiques précitées de la présente invention, ainsi que d'autres, seront mieux comprises à la lecture de la description suivante d'un exemple de réalisation de l'invention, donné à titre illustratif et non limitatif.

On va décrire ci-après un exemple de fabrication de semi-conducteurs ferromagnétiques selon l'invention de type GeMn, dans chacun desquels la phase ferromagnétique discontinue de GeMn a été obtenue par épitaxie par jets moléculaires à basse température après une préparation spécifique de la surface d'un substrat de GaAs (001).

On a dans un premier temps préparé la surface de ce substrat en mettant en oeuvre les étapes successives suivantes dans un bâti d'épitaxie dédié à l'épitaxie « EJM » de GeMn :
a) on a chauffé sous vide à 250° C le substrat de GaAs (001) dans ce bâti d'épitaxie pendant deux heures pour en désorber l'eau et les molécules de CO et CO₂,
b) on a déposé sur cette surface de GaAs (001) à 250° C une fine couche de germanium d'épaisseur égale à 0,5 nm, puis
c) on a réalisé la désoxydation du substrat de GaAs (001) sous un léger flux de germanium pendant 5 à 6 min. (le flux de Ge au niveau de substrat était de 1,1 x 10⁻⁸ Torr et correspondait à une vitesse de croissance de Ge de 0,15 nm/min.) à une température de l'ordre de 550° C pour ce substrat, étant précisé que dès l'apparition d'une reconstruction 2x1 mono-domaine (observée par « RHEED », i.e. diffraction d'électrons à haute énergie) qui caractérisait la fin de désorption de l'oxyde de gallium et d'arsenic, on a coupé le flux de Ge et abaissé la température du substrat à la température du dépôt de GeMn.

Ce traitement thermique a généré une couche de germanium à la surface du substrat de GaAs (001) d'épaisseur inférieure à 1 nm.

Dans un second temps, on a déposé sur ce substrat ainsi préparé et dans le même bâti d'épitaxie une couche de GeMn d'épaisseur égale à 80 nm à une température de 90 à 100° C pour ce substrat, via une épitaxie « EJM ». Dans ce mode de réalisation sous ultravide et à basse température, on a évaporé le germanium et le manganèse à partir de sources solides sur ce substrat, en utilisant des pressions partielles de germanium et de manganèse dans le flux au niveau du substrat respectivement de 1.8 10⁻⁸ Torr et 4 10⁻⁹ Torr. Ainsi, la vitesse de dépôt du semi-conducteur GeMn était de l'ordre de 1,3 nm/min. et la concentration moyenne en manganèse était de 6 % en fraction atomique.

Dans ces conditions de croissance, on a obtenu un semi-conducteur GeMn incorporant une phase discontinue sous la forme d'une couche mince dans laquelle on a observé une modulation latérale de la composition en manganèse sous forme de nano-colonnes ferromagnétiques perpendiculaires au plan de la couche mince et qui sont chacune constituées d'un alliage plus riche en manganèse que la matrice qui les entoure, à l'instar de la couche mince illustrée aux figures 1 et 2 du document précité WO-A1-2007/090946.

Par des méthodes d'analyse de composition en profondeur telles que la spectroscopie Auger et la spectroscopie « SIMS » de masse d'ions secondaires (« Secondary Ion Mass Spectroscopy »), la Demanderesse a établi, d'une part, la présence de traces de germanium à l'interface substrat de GaAs / couche de GeMn déposée et, d'autre part, l'absence de diffusion d'arsenic dans la couche déposée de GeMn.

D'une manière générale en référence à la présente invention, on notera que le contrôle du flux de germanium pour l'étape de désoxydation de la surface du substrat de GaAs (001), de la température de ce substrat pendant l'épitaxie ultérieure du semi-conducteur et des flux respectifs du ou de chaque élément semi-conducteur (e.g. Ge) et du ou de chaque élément magnétique (e.g. Mn) et de l'épaisseur déposée de ce semi-conducteur sont critiques pour réaliser l'épitaxie avec ces nano-colonnes riches en élément magnétique (e.g. Mn), et que ces paramètres sont susceptibles d'être modifiés dans une certaine mesure pour l'obtention de dimensions différentes des nano-colonnes avec par exemple une densité et/ou une concentration en cet élément magnétique différentes de celles décrites précédemment.

## Revendications

1. Méthode de préparation d'une surface d'un substrat à base de GaAs (001) pour la rendre apte à recevoir un semi-conducteur ferromagnétique déposé par épitaxie, lequel est choisi dans le groupe constitué par les semi-conducteurs des groupes III-V, IV et II-VI de la classification périodique à l'exception de GaAs et comprend en outre au moins un élément magnétique choisi dans le groupe constitué par le manganèse, le fer, le cobalt, le nickel et le chrome, **caractérisée en ce qu'**elle comprend une désoxydation sous vide de ladite surface sous un flux à base de germanium pour qu'en fin de désorption de l'oxyde d'arsenic et de gallium de ladite surface, cette dernière présente une reconstruction 2x1 mono-domaine et soit suffisamment plane et appauvrie en arsenic pour éviter toute diffusion d'arsenic du substrat vers le semi-conducteur ultérieurement déposé.

2. Méthode de préparation de surface selon la revendication 1, **caractérisée en ce qu'**elle est mise en oeuvre dans un bâti d'épitaxie par jets moléculaires dédié au dépôt ultérieur dudit semi-conducteur ferromagnétique, par exemple dans un bâti dédié au dépôt d'un semi-conducteur de type GeMn.

3. Méthode de préparation de surface selon la revendication 2, **caractérisée en ce qu'**il comprend en outre les étapes suivantes, mises en oeuvre dans ledit bâti d'épitaxie antérieurement à ladite désoxydation et de préférence à une température comprise entre 200 et 300° C :
a) un chauffage sous vide du substrat en particulier pour désorber l'eau et les molécules de CO et de CO₂ de ladite surface, puis
b) un dépôt sur ladite surface ainsi traitée d'une fine couche de germanium.

4. Méthode de préparation de surface selon une des revendications précédentes, **caractérisée en ce que** ledit flux de germanium au niveau du substrat lors de ladite désoxydation est compris entre 1,19 x 10⁻⁶ Pa et 1,73 x 10⁻⁶ Pa (0,9 x 10⁻⁸ Torr et 1,3 x 10⁻⁸ Torr).

5. Méthode de préparation de surface selon une des revendications précédentes, **caractérisée en ce que** ledit flux de germanium au niveau du substrat lors de ladite désoxydation correspond à une vitesse de croissance du germanium comprise entre 0,10 nm/min. et 0,20 nm/min.

6. Méthode de préparation de surface selon une des revendications précédentes, **caractérisée en ce que** la température du substrat lors de ladite désoxydation est comprise entre 500 et 600° C et est de préférence sensiblement égale à 550° C.

7. Méthode de préparation de surface selon la revendication 6, **caractérisée en ce que** dès l'apparition de ladite reconstruction 2x1 mono-domaine pour ladite surface, on supprime ledit flux de germanium et l'on abaisse la température du substrat à une valeur qui est proche de celle utilisée pour le dépôt ultérieur du semi-conducteur ferromagnétique et qui est de préférence comprise entre 80 et 200° C et par exemple entre 90 et 100° C dans le cas où ce semi-conducteur est à base de GeMn.

8. Méthode de préparation de surface selon une des revendications précédentes, **caractérisée en ce que** l'on soumet le substrat audit flux de germanium lors de ladite désoxydation pendant une durée comprise entre 5 min. et 6 min., pour l'obtention finale sur ladite surface d'une fine couche de germanium d'épaisseur inférieure à 1 nm.

9. Substrat à base de GaAs (001) dont une surface est apte à recevoir un semi-conducteur ferromagnétique déposé par épitaxie qui est choisi dans le groupe constitué par les semi-conducteurs des groupes III-V, IV et II-VI de la classification périodique à l'exception de GaAs et qui comprend en outre au moins un élément magnétique choisi dans le groupe constitué par le manganèse, le fer, le cobalt, le nickel et le chrome, **caractérisé en ce que** ladite surface présente une reconstruction 2x1 mono-domaine et est suffisamment pauvre en arsenic pour éviter toute diffusion d'arsenic de ladite surface vers ce semi-conducteur ferromagnétique, et de préférence **en ce que** ladite surface est recouverte d'une fine couche de germanium d'épaisseur de préférence inférieure à 1 nm.

10. Procédé de fabrication d'un semi-conducteur ferromagnétique qui est choisi dans le groupe constitué par les semi-conducteurs des groupes III-V, IV et II-VI de la classification périodique à l'exception du GaAs et qui comprend en outre au moins un élément magnétique choisi dans le groupe constitué par le manganèse, le fer, le cobalt, le nickel et le chrome, le semi-conducteur étant de préférence à base de germanium, ce procédé comprenant un dépôt par épitaxie par jets moléculaires de ce semi-conducteur sur un substrat dont la température pendant la croissance des cristaux est comprise entre 80 et 200° C et de préférence entre 90 et 100° C dans le cas où ce semi-conducteur est à base de GeMn, **caractérisé en ce qu'**il consiste à utiliser un substrat tel que défini à la revendication 9.

11. Procédé de fabrication d'un semi-conducteur ferromagnétique selon la revendication 10, **caractérisé en ce que** ce substrat est préparé par une méthode selon une des revendications 1 à 8.

12. Procédé de fabrication d'un semi-conducteur ferromagnétique à base de germanium selon la revendication 10 ou 11, **caractérisé en ce que** ledit dépôt par épitaxie est réalisé sous ultravide par évaporation du germanium et dudit au moins un élément magnétique à partir de sources solides sur le substrat, le semi-conducteur ainsi déposé comprenant des nano-colonnes riches en cet élément qui sont perpendiculaires à ladite surface et qui sont séparées entre elles par une matrice pauvre en cet élément.

13. Semi-conducteur ferromagnétique qui est choisi dans le groupe constitué par les semi-conducteurs des groupes III-V, IV et II-VI de la classification périodique à l'exception du GaAs, qui comprend en outre au moins un élément magnétique choisi dans le groupe constitué par le manganèse, le fer, le cobalt, le nickel et le chrome et qui est de préférence à base de germanium, ce semi-conducteur étant déposé par épitaxie par jets moléculaires sur une surface d'un substrat et comprenant des nano-colonnes riches en cet élément qui sont sensiblement perpendiculaires à ladite surface et qui sont séparées entre elles par une matrice pauvre en cet élément, **caractérisé en ce que** ce substrat est tel que défini à la revendication 9.

14. Utilisation d'un semi-conducteur ferromagnétique selon la revendication 13 pour injecter des spins dans ce substrat à base de GaAs (001), par exemple afin que ce substrat émette de la lumière sous forme de diodes électroluminescentes en combinant l'émission de la lumière avec une injection sélective polarisée en spin.

15. Utilisation d'un semi-conducteur ferromagnétique selon la revendication 13 pour réaliser des transistors travaillant en courant polarisé en spin, ce courant circulant dans le semi-conducteur déposé sur ce substrat à base de GaAs (001).

## Patentansprüche

1. Verfahren zur Präparierung einer Oberfläche eines Substrates auf der Basis von GaAs (001), um sie geeignet zu machen, einen ferromagnetischen Halbleiter, der durch Epitaxie abgeschieden wird, aufzunehmen, der aus der Gruppe, bestehend aus den Halbleitern der Gruppen III-V, IV und II-VI des Periodensystems, mit der Ausnahme von GaAs, ausgewählt ist, und der außerdem wenigstens ein magnetisches Element, ausgewählt aus der Gruppe, bestehend aus Mangan, Eisen, Kobalt, Nickel und Chrom, umfasst, **dadurch gekennzeichnet, dass** es unter Vakuum eine Desoxidation der genannten Oberfläche unter einem Strom auf Germaniumbasis umfasst, um letztendlich eine Desorption des Arsen- und des Galliumoxids von der Oberfläche zu bewirken, wobei diese letzte eine Monodomänen-2x1-Rekonstruktion aufweist und genügend eben und an Arsen verarmt ist, um jede Diffusion von Arsen des Substrates zu dem später abgeschiedenen Halbleiter zu vermeiden.

2. Verfahren zur Oberflächenpräparierung gemäß Anspruch 1, **dadurch gekennzeichnet, dass** es in einem Epitaxie-Trageelement durch Molekülstrahlen, zugeschnitten auf die spätere Abscheidung des ferromagnetischen Halbleiters, z.B. in einem Trageelement, das auf die Abscheidung eines Halbleiters des Typs GeMn zugeschnitten ist, durchgeführt wird.

3. Verfahren zur Oberflächenpräparierung gemäß Anspruch 2, **dadurch gekennzeichnet, dass** es außerdem die folgenden Stufen umfasst, die in dem Epitaxie-Trageelement vor der Desoxidation und vorzugsweise bei einer Temperatur zwischen 200 und 300°C durchgeführt werden:
a) eine Erwärmung des Substrates unter Vakuum, um insbesondere Wasser und CO- und CO₂-Moleküle von der Oberfläche zu desorbieren, danach
b) auf der so behandelten Oberfläche Abscheidung einer feinen Germaniumschicht.

4. Verfahren zur Oberflächenpräparierung gemäß einem der vorangehenden Ansprüche, **dadurch gekennzeichnet, dass** der Germaniumstrom auf der Ebene des Substrates bei der Desoxidation zwischen 1,11 x 10⁻⁶ Pa und 1,73 x 10⁻⁶ Pa (0,9 x 10⁻⁸ Torr und 1,3 x 10⁻⁸ Torr) liegt.

5. Verfahren zur Oberflächenpräparierung gemäß einem der vorangehenden Ansprüche, **dadurch gekennzeichnet, dass** der Germaniumstrom auf der Ebene des Substrates während der Desoxidation einer Wachstumsgeschwindigkeit des Germaniums von zwischen 0,10 nm/min und 0,20 nm/min entspricht.

6. Verfahren zur Oberflächenpräparierung gemäß einem der vorangehenden Ansprüche, **dadurch gekennzeichnet, dass** die Temperatur des Substrates während der Desoxidation zwischen 500 und 600°C liegt und vorzugsweise etwa gleich 550°C ist.

7. Verfahren zur Oberflächenpräparierung gemäß Anspruch 6, dadurch gekennzezchnet, dass man ab dem Auftreten der Monodomänen-2x1-Rekonstruktion für die Oberfläche den Germaniumstrom unterdrückt und die Temperatur des Substrates auf einen Wert senkt, der nahe demjenigen ist, der für die spätere Abscheidung des ferromagnetischen Halbleiters verwendet wird und der vorzugsweise zwischen 80 und 200°C und beispielsweise zwischen 90 und 100°C für den Fall liegt, dass dieser Halbleiter auf Basis von GeMn ist.

8. Verfahren zur Oberflächenpräparierung gemäß einem der vorangehenden Ansprüche, **dadurch gekennzeichnet, dass** man das Substrat bei der Desoxidation während einer Dauer von zwischen 5 min und 6 min dem Germaniumstrom unterwirft, um schließlich auf der Oberfläche eine dünne Germaniumschicht mit einer Dicke von unter 1 mn zu erhalten.

9. Substrat auf der Basis von GaAs (001), von dem eine Oberfläche geeignet ist, einen ferromagnetischen Halbleiter aufzunehmen, der durch Epitaxie abgeschieden wird, der aus der Gruppe, bestehend aus den Halbleitern der Gruppen III-V, IV und II-VI des Periodensystems, mit Ausnahme von GaAs, ausgewählt ist und der außerdem wenigstens ein magnetisches Element, ausgewählt aus der Gruppe, bestehend aus Mangan, Eisen, Kobalt, Nickel und Chrom, umfasst, **dadurch gekennzeichnet, dass** die Oberfläche eine Monodomänen-2x1-Rekonstruktion aufweist und genügend arm an Arsen ist, um jede Diffusion von Arsen von der Oberfläche zu diesem ferromagnetischen Halbleiter zu vermeiden, und vorzugsweise dadurch, dass die Oberfläche mit einer dünnen Germaniumschicht mit einer Dicke von vorzugsweise weniger als 1 nm überzogen ist.

10. Verfahren zur Herstellung eines ferromagnetischen Halbleiters, der aus der Gruppe, bestehend aus den Halbleitern der Gruppen III-V, IV und II-VI des Periodensystems, ausgenommen GaAs, ausgewählt ist und der außerdem wenigstens ein magnetisches Element, ausgewählt aus der Gruppe, bestehend aus Mangan, Eisen, Kobalt, Nickel und Chrom, umfasst, wobei der Halbleiter vorzugsweise auf der Basis von Germanium ist, dieses Verfahren eine Abscheidung durch Epitaxie durch Molekühlstrahlen dieses Halbleiters auf einem Substrat, dessen Temperatur während des Wachsens der Kristalle zwischen 80 und 200°C und vorzugsweise zwischen 90 und 100°C für den Fall ist, dass dieser Halbleiter auf Basis von GeMn ist, umfasst, **dadurch gekennzeichnet, dass** es darin besteht, ein Substrat, wie es in Anspruch 9 definiert ist, zu verwenden.

11. Verfahren zur Herstellung eines ferromagnetischen Halbleiters gemäß Anspruch 10, **dadurch gekennzeichnet, dass** dieses Substrat durch ein Verfahren gemäß einem der Ansprüche 1 bis 8 präpariert wird.

12. Verfahren zur Herstellung eines ferromagnetischen Halbleiters auf der Basis von Germanium gemäß Anspruch 10 oder 11, **dadurch gekennzeichnet, dass** die Abscheidung durch Epitaxie unter Ultrahochvakuum durch Verdampfung des Germaniums und des wenigstens einen magnetischen Elements aus Fest-stoffquellen auf dem Substrat durchgeführt wird, wobei der so abgeschiedene Halbleiter Nanosäulen, die reich an diesem Element sind, umfasst, die senkrecht zu der Oberfläche sind und die untereinander durch eine Matrix, die an diesem Element arm ist, getrennt sind.

13. Ferromagnetischer Halbleiter, der aus der Gruppe, bestehend aus Halbleitern der Gruppen III-V, IV und II-VI des Periodensystems, außer GaAs, ausgewählt ist, der außerdem wenigstens ein magnetisches Element, ausgewählt aus der Gruppe, bestehend aus Mangan, Eisen, Kobalt, Nickel und Chrom, umfasst und der vorzugsweise auf der Basis von Germanium ist, wobei dieser Halbleiter durch Epitaxie durch Molekülstrahlen auf einer Oberfläche eines Substrats abgeschieden ist und Nanosäulen umfasst, die reich an diesem Element sind, die etwa senkrecht zu der Oberfläche sind und die voneinander durch eine Matrix, die arm an diesem Element ist, getrennt sind, **dadurch gekennzeichnet, dass** dieses Substrat wie in Anspruch 9 definiert ist.

14. Verwendung eines ferromagnetischen Halbleiters gemäß Anspruch 13, um Spins in dieses Substrat auf Basis von GaAs (001) zu injizieren, beispielsweise damit dieses Substrat Licht in Form von elektrolumineszenten Dioden in Kombination mit der Emission des Lichts mit einer selektiven Spinpolarisierten Injektion emittiert.

15. Verwendung eines ferromagnetischen Halbleiters gemäß Anspruch 13, um Transistoren zu verwirklichen, die mit Spinpolarisiertem Strom arbeiten, wobei dieser Strom in dem Halbleiter, der auf diesem Substrat auf Basis von GaAs (001) abgeschieden ist, zirkuliert.

## Claims

1. A method for preparing a surface of a substrate based on GaAs (001) in order to make it capable of receiving a ferromagnetic semiconductor, deposited by epitaxy, which is selected from the group consisting of the semiconductors of groups III-V, IV and II-VI of the periodic table with the exception of GaAs and furthermore comprises at least one magnetic element selected from the group consisting of manganese, iron, cobalt, nickel and chromium, **characterized in that** it comprises vacuum deoxidation of said surface under a germanium-based flow so that, at the end of desorption of the arsenic and gallium oxide of said surface, the latter has a monodomain 2×1 reconstruction and is sufficiently planar and depleted of arsenic to avoid any diffusion of arsenic from the substrate to the semiconductor subsequently deposited.

2. The surface preparation method as claimed in claim 1, **characterized in that** it is carried out in a molecular beam epitaxy unit dedicated to the subsequent deposition of said ferromagnetic semiconductor, for example in a unit dedicated to the deposition of a semiconductor of the GeMn type.

3. The surface preparation method as claimed in claim 2, **characterized in that** it furthermore comprises the following steps, carried out in said epitaxy unit before said deoxidation and preferably at a temperature of between 200 and 300°C:
a) vacuum heating of the substrate, particularly in order to desorb the water and molecules of CO and CO₂ from said surface, then
b) deposition of a germanium thin film on said surface treated in this way.

4. The surface preparation method as claimed in one of the preceding claims, **characterized in that** said germanium flow at the substrate during said deoxidation is between 1.19 x 10⁻⁶ Pa and 1.73 x 10⁻⁶ Pa (0.9×10⁻⁸ Torr and 1.3×10⁻⁸ Torr).

5. The surface preparation method as claimed in one of the preceding claims, **characterized in that** said germanium flow at the substrate during said deoxidation corresponds to a germanium growth rate of between 0.10 nm/min and 0.20 nm/min.

6. The surface preparation method as claimed in one of the preceding claims, **characterized in that** the temperature of the substrate during said deoxidation is between 500 and 600°C, and is preferably substantially equal to 550°C.

7. The surface preparation method as claimed in claim 6, **characterized in that**, upon appearance of said monodomain 2×1 reconstruction for said surface, said germanium flow is stopped and the temperature of the substrate is lowered to a value which is close to that used for the subsequent deposition of the ferromagnetic semiconductor and which is preferably between 80 and 200°C, and for example between 90 and 100°C in the case in which this semiconductor is based on GeMn.

8. The surface preparation method as claimed in one of the preceding claims, **characterized in that** the substrate is subjected to said germanium flow during said deoxidation for a time of between 5 min and 6 min, in order to finally obtain a germanium thin film with a thickness of less than 1 nm on said surface.

9. A substrate based on GaAs (001), a surface of which is capable of receiving a ferromagnetic semiconductor, deposited by epitaxy, which is selected from the group consisting of the semiconductors of groups III-V, IV and II-VI of the periodic table with the exception of GaAs and which furthermore comprises at least one magnetic element selected from the group consisting of manganese, iron, cobalt, nickel and chromium, **characterized in that** said surface has a monodomain 2×1 reconstruction and has a sufficiently low arsenic content to avoid any diffusion of arsenic from said surface to this ferromagnetic semiconductor, and preferably **in that** said surface is covered with a germanium thin film with a thickness preferably of less than 1 nm.

10. A method for manufacturing a ferromagnetic semiconductor which is selected from the group consisting of the semiconductors of groups III-V, IV and II-VI of the periodic table with the exception of GaAs and which furthermore comprises at least one magnetic element selected from the group consisting of manganese, iron, cobalt, nickel and chromium, the semiconductor preferably being based on germanium, this method comprising deposition of this semiconductor by molecular beam epitaxy on a substrate the temperature of which during the growth of the crystals is between 80 and 200°C, and preferably between 90 and 100°C in the case in which this semiconductor is based on GeMn, **characterized in that** it consists in using a substrate as defined in claim 9.

11. The method for manufacturing a ferromagnetic semiconductor as claimed in claim 10, **characterized in that** this substrate is prepared by a method as claimed in one of claims 1 to 8.

12. The method for manufacturing a germanium-based ferromagnetic semiconductor as claimed in claim 10 or 11, **characterized in that** said deposition by epitaxy is carried out in ultrahigh vacuum by evaporation of the germanium and of said at least one magnetic element from solid sources onto the substrate, the semiconductor deposited in this way comprising nanocolumns rich in this element, which are perpendicular to said surface and which are separated from one another by a matrix that has a low content of this element.

13. A ferromagnetic semiconductor which is selected from the group consisting of the semiconductors of groups III-V, IV and II-VI of the periodic table with the exception of GaAs, which furthermore comprises at least one magnetic element selected from the group consisting of manganese, iron, cobalt, nickel and chromium, and which is preferably based on germanium, this semiconductor being deposited by molecular beam epitaxy on a surface of a substrate and comprising nanocolumns rich in this element, which are substantially perpendicular to said surface and which are separated from one another by a matrix that has a low content of this element, **characterized in that** this substrate is as defined in claim 9.

14. The use of a ferromagnetic semiconductor as claimed in claim 13 for injecting spins into this substrate based on GaAs (001), for example so that this substrate emits light in the form of light-emitting diodes while combining the emission of the light with selective spin-polarized injection.

15. The use of a ferromagnetic semiconductor as claimed in claim 13 for producing transistors operating with spin-polarized current, this current flowing in the semiconductor deposited on this substrate based on GaAs (001).
